# FASCICULE DE BREVET EUROPEEN

(11) **EP 0 562 961 B1**
(45) Date de publication et mention de la délivrance du brevet: **23.10.1996**
(21) Numéro de dépôt: 93400764.2
(22) Date de dépôt: 24.03.1993
(51) Int. Cl.: H03G 3/20

(54) **Procédé de CAG dans un récepteur superhétérodyne et récepteur mettant en oeuvre ce procédé**
Verfahren zur automatischen Verstärkungseinstellung in einem Superheterodynempfänger und Empfänger, der ein solches Verfahren verwendet
Method of automatic gain control of a superheterodyne receiver and receiver using such a method

(30) Priorité: 27.03.1992 FR 9203756
(43) Date de publication de la demande: 29.09.1993
(73) Titulaire: ALCATEL TELSPACE, 92734 Nanterre Cédex (FR)
(72) Inventeur: Lopez, Pierre, F-92300 Levallois-Perret (FR); Podolak, Thierry, F-92300 Levallois-Perret (FR)
(74) Mandataire: Pothet, Jean Rémy Emile Ludovic

(56) Documents cités:
- US-A- 4 330 859
- US-A- 4 551 688
- US-A- 4 574 252

## Description

L'invention concerne un procédé pour commande automatique de gain (CAG) dans un récepteur superhétérodyne de signaux radioélectriques et un récepteur pour la mise en oeuvre de ce procédé.

Le procédé est avantageux pour des applications en télécommunications utilisant l'Accès Multiple à Répartition Temporelle (AMRT). Selon l'AMRT, les signaux de télécommunications sont répartis en paquets séparés temporellement pour la transmission par voie hertzienne. La commande de gain améliorée selon l'invention sera particulièrement avantageuse pour des signaux présentant des variations d'intensité ayant une ou plusieurs des caractéristiques suivantes :
- les variations sont rapides, par rapport à la durée d'un paquet,
- les variations sont fortes, par rapport à la dynamique de la chaîne amplificatrice du récepteur, et/ou
- les variations sont imprévisibles, et donc exigeant une réaction du circuit de réception pratiquement en temps réel.

Le récepteur intéressé par la présente demande est destiné à recevoir des signaux RF (radiofréquence). De façon générale, les signaux reçus sont de faible intensité, et sont amplifiés avant l'utilisation. Ils peuvent être amplifiés soit après démodulation directe en hyperfréquence, en utilisant des amplificateurs bande de base, par exemple, soit à une fréquence intermédiaire FI bien inférieure à la fréquence des signaux reçus, de l'ordre de 10 MHz à 200 MHz en règle générale. Le procédé selon l'invention ne s'applique que dans ce deuxième cas d'utilisation d'une fréquence intermédiaire FI, c'est-à-dire dans un récepteur superhétérodyne.

Un récepteur bien connu de l'homme de l'art comprend, en aval de l'antenne de réception, un oscillateur local qui génère un signal à la fréquence ajustable F_{LO} égale à la fréquence de réception F_{R} ± la fréquence intermédiaire FI (FI = F_{R} ± F_{LO}), ainsi qu'un mélangeur qui effectue la conversion du signal hyperfréquence reçu sur l'antenne (à la fréquence F_{R}), en signal en fréquence intermédiaire FI, qui sera traité par la suite dans les différents circuits du récepteur selon l'application envisagée. Préalablement à ces différents traitements, visant à extraire l'information utile des signaux reçus, une amplification du signal FI est effectuée, de préférence avec un minimum de dégradation du signal.

En effet, le choix de l'amplificateur résulte en général d'un compromis tenant compte de plusieurs paramètres à optimiser, parmi lesquels figurent, par exemple, les performances (gain, linéarité, bande passante, dynamique, facteur de bruit, distorsions provenant de saturation ou d'intermodulation, bruit de phase, conversions amplitude/amplitude et amplitude/phase, etc...), le coût de l'amplificateur et, pour certaines applications, la consommation, la dissipation thermique, l'encombrement, le poids...

De façon générale, un amplificateur présentant des meilleures performances coûte plus cher. C'est pour cette raison que de nombreuses inventions de ces dernières années ont pour but d'abaisser le coût, sans sacrifier les performances, des circuits d'amplification pour récepteurs.

L'application envisagée pour le récepteur impose ses propres contraintes sur les caractéristiques de la chaîne amplificatrice. Pour des signaux transmis par une liaison hertzienne terrestre fixe, des variations aléatoires d'intensité reçue peuvent être générées par la propagation atmosphérique. La dynamique de la chaîne amplificatrice de réception doit être suffisamment grande pour compenser la dynamique des signaux à l'émission, combinée avec la dynamique des variations aléatoires dues aux conditions de propagation. Pour des liaisons entre mobiles et une station fixe, de fortes variations d'intensité de signaux reçus peuvent résulter des différences de longueur du chemin de propagation parcouru (l'intensité reçue varie, selon une première approximation, inversement comme le carré de la distance parcourue).

Il est connu dans l'art antérieur l'utilisation d'un circuit de commande automatique de gain dans un récepteur, pour pallier les variations d'intensité de signal reçu qui peuvent, dans certaines conditions, être plus fortes que la dynamique de la chaîne amplificatrice du récepteur.

Il a été proposé par la demanderesse, dans la demande de brevet français n°92.03754, déposée le même jour que la présente demande, un système de contrôle automatique de gain en boucle ouverte pour récepteur hétérodyne. Dans le récepteur selon cette demande, l'amplitude du signal reçu est mesurée pendant une certaine durée, avant l'application du signal à l'entrée de la chaîne amplificatrice. Ainsi, pendant toute cette durée de la mesure de l'intensité reçue, il est nécessaire de retarder le signal avant son application à l'entrée de la chaîne amplificatrice, pour permettre au circuit CAG d'ajuster le gain qui sera appliqué pour l'amplification du signal.

Le problème se pose alors d'obtenir le retard nécessaire pour pouvoir réaliser la boucle ouverte de CAG et laisser le temps nécessaire pour effectuer la mesure et pour commander le gain avant l'arrivée du signal sur l'entrée de l'amplificateur.

En particulier, dans le cas d'une transmission de signaux par paquets temporels, il est connu d'effectuer la mesure de l'intensité d'un paquet après son application à l'entrée de la chaîne amplificatrice, pour permettre la commande automatique de gain de l'amplificateur en boucle fermée. Le gain ainsi commandé sera donc appliqué aux prochains signaux reçus. US-A-4330 859 divulgue un tel système de commande automatique de gain qui n'est pas utilisable si les variations sont vraiment imprévisibles car il requiert une répartition temporelle périodique fixe.

Dans le cadre de la présente invention, par contre, la mesure de l'intensité du signal est utilisée pour commander le gain qui sera utilisé pour l'amplification de ce même signal. Ceci implique nécessairement un moyen pour retarder le signal pendant toute la durée de la mesure.

Dans l'état de la technique, l'on connaît dans un domaine technique proche de celui de la demande, les radars, l'utilisation d'une ligne à retard à ondes acoustiques de surface (OAS). Dans ce cas, la durée maximale de mesure est limitée par le retard maximal que l'on sait obtenir avec une ligne de retard OAS. L'utilisation d'une ligne à retard à ondes acoustiques de surface est courant dans certains circuits récepteurs fonctionnant en fréquence intermédiaire et même classique dans des applications telles que les radars et les sonars.

Cependant il subsiste plusieurs inconvénients à leur utilisation, dont on se passerait bien, particulièrement dans des applications destinées à une plus grande diffusion, tels les récepteurs de radiotéléphonie. En effet, ces composants OAS sont chers, encombrants, fragiles, et de plus, n'ont que des performances limitées. Le délai maximal obtenu par ces composants OAS est de l'ordre de 25 µs, et leurs pertes d'insertion sont au minimum de l'ordre de 25 dB. Dans les cas où l'on peut s'attendre à de fortes variations d'intensité reçues sur une échelle de temps inférieure à la durée d'un paquet de transmission, la fiabilité de la mesure de l'intensité devient aléatoire, la mesure pouvant être effectuée pendant la durée du paquet mais en dehors d'une période de variation forte et rapide. Les fortes pertes d'insertion de ces composants prohibent leur utilisation en séries pour obtenir un retard plus important dans la voie principale empruntée par le signal avant son amplification et son traitement.

Le procédé selon l'invention permet de pallier ces inconvénients.

L'invention propose donc un procédé de commande automatique de gain dans un récepteur superhétérodyne de signaux radioélectriques, ce procédé comprenant en outre les étapes suivantes :
- division du signal FI en deux voies, une voie principale et une voie secondaire ;
- retard d'un délai τ du signal FI dans la voie principale ;
- mesure de puissance du signal dans la voie secondaire pendant une durée inférieure ou égale à τ;
- commande de gain d'un amplificateur FI en fonction de la puissance mesurée ;
- amplification du signal FI retardé de τ;
la fréquence intermédiaire FI étant choisie parmi des fréquences utilisées couramment pour des signaux vidéo dans des appareils grand public.

En effet, une sélection de fréquence intermédiaire FI en dehors des plages de fréquences habituellement utilisées dans l'art antérieur pour des circuits récepteurs de signaux hyperfréquence (dans des radars par exemple), autorise l'utilisation de composants qui ont été développés et commercialisés pour des applications grand public, dans des circuits de signaux de chrominance pour des téléviseurs couleurs par exemple, ou encore dans des magnétoscopes.

Selon une caractéristique de l'invention, la fréquence intermédiaire FI sera avantageusement choisie dans une gamme de fréquences supérieures à 1 MHz et inférieures à 10 MHz, soit un ordre de grandeur de moins que les fréquences FI habituellement utilisées par les radaristes pour des circuits récepteurs de signaux hyperfréquence de radar.

Selon d'autres caractéristiques préférées de l'invention, le délai de retard τ est inférieur à 1 ms, supérieur à 30 µs, égal à 64 µs, ou à 128 µs. Ces délais sont d'environ 2 à 5 fois plus grands que ceux obtenus couramment par des lignes OAS.

En effet, il existe actuellement sur le marché des composants lignes à retard sur verre et filtres "peigne", destinés aux applications vidéo grand public, fonctionnant par exemple à des fréquences nominales de 3,58 ou de 4,43 MHz, capables de fournir un retard nominal de 64 ou de 128 µs. Les volumes de production très importants de ces composants autorisent leur commercialisation à des prix plusieurs dizaines, voire centaines, de fois inférieurs à ceux pratiqués pour les lignes OAS. De plus, les pertes d'insertion de ces composants vidéo sont couramment inférieures à 10 dB, soit parfois plus de deux ordres de grandeur de différence par rapport aux composants OAS.

L'invention propose également un récepteur dans lequel est mis en oeuvre le procédé de l'invention. Le récepteur selon l'invention, comme d'autres récepteurs connus, comprend en outre :
- un diviseur du signal en deux voies ;
- une voie principale ;
- une ligne à retard sur la voie principale ;
- un amplificateur FI fonctionnant en fréquence intermédiaire FI et dont l'entrée est raccordée à la sortie de la ligne à retard, (la fréquence FI étant choisie selon le procédé de l'invention);
- une voie secondaire ;
- un détecteur de niveau de puissance de signal connecté sur la voie secondaire ;
- un dispositif de commande de gain, situé en aval du détecteur de puissance sur la voie secondaire, et dont la sortie est raccordée à l'amplificateur FI pour en commander le gain ;
la ligne à retard utilisée dans ce récepteur étant une ligne à retard vidéo.

Selon une caractéristique préférentielle, la ligne à retard vidéo est un composant courant des équipements de télévision grand public.

Selon une autre caractéristique préférentielle, la ligne à retard vidéo est conforme à celles utilisées dans les circuits de chrominance de téléviseurs couleurs (pour les systèmes NTSC, PAL, ou PAL/SECAM).

Selon une caractéristique alternative, la ligne à retard vidéo est conforme à celles utilisées dans les magnétoscopes.

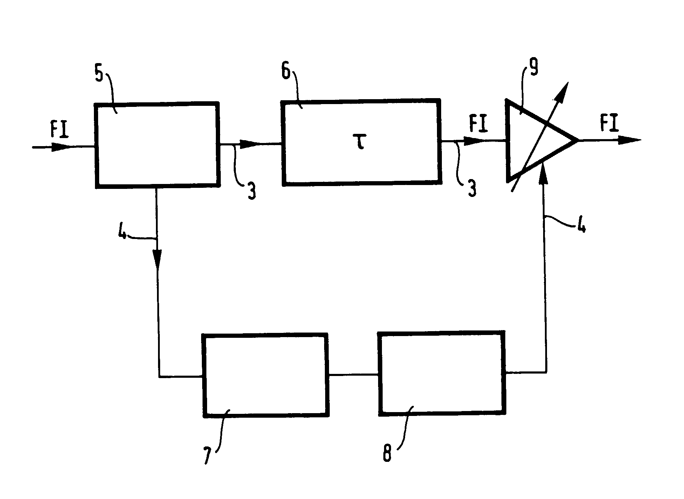

D'autres caractéristiques et avantages de l'invention ressortiront de la description détaillée qui suit de la figure unique annexée, qui montre de façon schématique un exemple non limitatif d'un récepteur pour la mise en oeuvre du procédé selon l'invention.

Sur la figure unique, l'on voit d'abord l'entrée d'un signal à la fréquence intermédiaire FI. Un diviseur de puissance 5 sépare une partie de la puissance du signal FI sur une voie secondaire 4 de mesure de puissance et de commande de gain. Cette voie secondaire 4 est une boucle avant (aussi appelé boucle ouverte) pour Commande Automatique de Gain (CAG).

Sur la voie principale 3, la sortie du diviseur 5 est raccordée à l'entrée d'une ligne à retard 6, où le signal FI sera retardé d'un délai τ avant son application à l'entrée de l'amplificateur FI à gain variable 9.

Pendant le délai de retard τ du signal sur la voie principale 3, un détecteur de puissance 7 effectue la mesure de puissance de la partie du signal FI acheminée dans la voie secondaire 4, ce qui permet de connaître la puissance de signal reçue. Le résultat de cette mesure de puissance est ensuite communiqué vers des moyens 8 de commande de gain. Les moyens de commande de gain 8 agissent sur l'amplificateur FI à gain variable 9 avant l'arrivée du signal FI retardé, par la voie principale 3, sur l'entrée de l'amplificateur 9.

Le procédé selon l'invention est caractérisé par un choix particulier de la fréquence FI, parmi les fréquences utilisées couramment pour des signaux vidéo dans des appareils grand public. Ce choix de fréquence FI autorise l'utilisation d'une ligne à retard vidéo 6 pour obtenir le retard du signal sur la voie principale 3 par un délai de τ. L'un des avantages du procédé selon l'invention est que le délai τ ainsi obtenu est suffisamment long pour permettre une meilleure précision et une meilleure fiabilité des mesures effectuées dans la boucle avant de CAG, donc une meilleure commande de gain permettant d'obtenir une meilleure information du signal à la sortie de l'amplificateur FI 9.

La fréquence intermédiaire FI est avantageusement comprise entre 1 et 10 MHz. On trouve en effet un nombre important de lignes à retard dont les fréquences de travail sont comprises entre ces valeurs, et ce chez différents fabricants. La majorité des lignes à retard courantes fonctionne à des fréquences comprises entre 2,8 et 5,2 MHz, ces lignes à retard étant disponibles sur les catalogues des fabricants et donc à bas prix. Plus spécifiquement, les lignes à retard fonctionnant à une fréquence de 4,43 MHz ou à 3,58 MHz sont très courantes puisqu'elles sont utilisées dans les magnétoscopes et dans les téléviseurs grand public. Leur bande passante est habituellement de l'ordre de 1 MHz autour de ces fréquences centrales. La fréquence centrale de 4,43 MHz est notamment employée pour le système PAL-SECAM en Europe et celle de 3,58 MHz pour le système NTSC ou PAL brésilien et argentin.

Comme indiqué précédemment, plus le délai τ est important, plus la précision est élevée. Ce délai de retard τ est préférentiellement inférieur à 1 ms et supérieur à 30 µs. En particulier, pour les téléviseurs et les magnétoscopes, les lignes à retard utilisées apportent un retard respectif de 64 µs et de 128 µs.

L'encombrement de ces composants vidéo est moindre que celui des lignes à retard OAS, et ces composants vidéo sont aussi moins fragiles. Leurs pertes d'insertion plus faibles autorisent l'utilisation d'une chaîne amplificatrice de gain plus faible, limitant la consommation et diminuant la dissipation thermique dans le circuit récepteur.

En plus des avantages techniques obtenus par l'invention, il y a un avantage majeur sur le plan industriel, à savoir que le coût des lignes à retard vidéo est plusieurs dizaines, voire centaines, de fois inférieur à celui des lignes à retard OAS.

## Revendications

1. Procédé de commande automatique de gain dans un récepteur superhétérodyne de signaux radioélectriques, du type consistant notamment à :
- diviser le signal en fréquence intermédiaire en deux voies, une voie principale (3) et une voie secondaire (4);
- retarder d'une durée τ le signal en fréquence intermédiaire dans ladite voie principale (3) et appliquer le signal retardé à l'entrée d'un amplificateur (9);
- mesurer la puissance du signal en fréquence intermédiaire dans ladite voie secondaire (4) pendant une durée inférieure ou égale à ladite durée τ;
- commander le gain dudit amplificateur (9) en fonction de ladite puissance mesurée;
ladite fréquence intermédiaire étant choisie parmi des fréquences utilisées couramment pour des signaux vidéo dans des appareils grand public.

2. Procédé selon la revendication 1, caractérisé en ce que ladite fréquence intermédiaire est comprise entre 1 MHz et 10 MHz.

3. Procédé selon la revendication 2, caractérisé en ce que ladite fréquence intermédiaire est comprise entre 2,8 et 5,2 MHz.

4. Procédé selon la revendication 3, caractérisé en ce que ladite fréquence intermédiaire est de 4,43 ± 1 MHz.

5. Procédé selon la revendication 3, caractérisé en ce que ladite fréquence intermédiaire est de 3,58 ± 1 MHz.

6. Procédé selon l'une quelconque des revendications 1 à 5, caractérisé en ce que ladite durée τ est inférieure à 1 ms.

7. Procédé selon l'une quelconque des revendications 1 à 6, caractérisé en ce que ladite durée τ est supérieure à 30 µs.

8. Procédé selon l'une quelconque des revendications 1 à 7, caractérisé en ce que ladite durée τ est de 64 µs.

9. Procédé selon l'une quelconque des revendications 1 à 7, caractérisé en ce que ladite durée τ est de 128 µs.

10. Récepteur superhétérodyne de signaux radioélectriques pour la mise en oeuvre du procédé selon l'une des revendications 1 à 9, du type comprenant:
- un diviseur (5) d'un signal en fréquence intermédiaire en une voie principale (3) et en une voie secondaire (4);
- une ligne à retard (6) sur ladite voie principale (3) retardant ledit signal en fréquence intermédiaire d'une durée τ;
- un amplificateur (9) à gain variable fonctionnant en fréquence intermédiaire et dont l'entrée est raccordée à la sortie de ladite ligne à retard (6);
- un détecteur (7) de niveau de puissance de signal connecté sur ladite voie secondaire (4);
- un dispositif (8) de commande de gain, situé en aval dudit détecteur de niveau de puissance (7), et dont la sortie est raccordée audit amplificateur (9) pour en commander le gain;
ladite ligne à retard (6) étant une ligne à retard vidéo.

11. Récepteur selon la revendication 10, caractérisé en ce que ladite ligne à retard vidéo (6) est du type utilisée dans les équipements de télévision grand public.

12. Récepteur selon l'une des revendications 10 et 11, caractérisé en ce que ladite ligne à retard vidéo (6) est conforme à celles utilisées dans les circuits de chrominance de téléviseurs couleurs de standard NTSC, PAL, ou PAL/SECAM et en ce que ladite durée τ est égale à 64 µs.

13. Récepteur selon l'une quelconque des revendications 10 et 11, caractérisé en ce que ladite ligne à retard vidéo (6) est conforme à celles utilisées dans les magnétoscopes et en ce que ladite durée τ est égale à 128 µs.

## Patentansprüche

1. Verfahren zur automatischen Verstärkungssteuerung in einem Superheterodynempfänger für funkelektrische Signale, das insbesondere darin besteht:
- das Zwischenfrequenz-Signal in zwei Kanäle, einen Hauptkanal (3) und einen Nebenkanal (4), aufzuteilen;
- das Zwischenfrequenz-Signal im Hauptkanal (3) um eine Zeit τ zu verzögern und das verzögerte Signal an den Eingang eines Verstärkers (9) zu legen;
- die Leistung des Zwischenfrequenz-Signals im Nebenkanal (4) während einer Dauer von höchstens τ zu messen;
- die Verstärkung des Verstärkers (9) in Abhängigkeit von der gemessenen Leistung zu steuern;
wobei die Zwischenfrequenz unter den Frequenzen ausgewählt wird, die üblicherweise für Videosignale in Geräten für ein breites Publikum verwendet werden.

2. Verfahren nach Anspruch 1, dadurch gekennzeichnet, daß die Zwischenfrequenz zwischen 1 MHz und 10 MHz liegt.

3. Verfahren nach Anspruch 2, dadurch gekennzeichnet, daß die Zwischenfrequenz zwischen 2,8 und 5,2 MHz liegt.

4. Verfahren nach Anspruch 3, dadurch gekennzeichnet, daß die Zwischenfrequenz 4,43 ± 1 MHz beträgt.

5. Verfahren nach Anspruch 3, dadurch gekennzeichnet, daß die Zwischenfrequenz 3,58 ± 1 MHz beträgt.

6. Verfahren nach einem beliebigen der Ansprüche 1 bis 5, dadurch gekennzeichnet, daß die Dauer τ unter 1 ms liegt.

7. Verfahren nach einem beliebigen der Ansprüche 1 bis 6, dadurch gekennzeichnet, daß die Dauer τ über 30 µs liegt.

8. Verfahren nach einem beliebigen der Ansprüche 1 bis 7, dadurch gekennzeichnet, daß die Dauer τ 64 µs beträgt.

9. Verfahren nach einem beliebigen der Ansprüche 1 bis 7, dadurch gekennzeichnet, daß die Dauer τ 128 µs beträgt.

10. Superheterodynempfänger für funkelektrische Signale zur Anwendung des Verfahrens gemäß einem der Ansprüche 1 bis 9, der aufweist:
- eine Schaltung (5) zur Aufteilung des Zwischenfrequenz-Signals in einen Hauptkanal (3) und einen Nebenkanal (4);
- eine Verzögerungsleitung (6) auf dem Hauptkanal (3), die das Zwischenfrequenz-Signal um eine Dauer τ verzögert;
- einen Verstärker (9) mit variabler Verstärkung, der mit der Zwischenfrequenz arbeitet und dessen Eingang mit dem Ausgang der Verzögerungsleitung verbunden ist (6);
- einen Detektor (7) für den Signal-Leistungspegel, der mit dem Nebenkanal (4) verbunden ist;
- eine Verstärkungssteuerungsvorrichtung (8), die sich hinter dem Leistungspegeldetektor (7) befindet und deren Ausgang an den Verstärker (9) angeschlossen ist, um dessen Verstärkung zu steuern;
wobei die Verzögerungsleitung (6) in diesem Empfänger eine Videosignal-Verzögerungsleitung ist.

11. Empfänger nach Anspruch 10, dadurch gekennzeichnet, daß die Videosignal-Verzögerungsleitung (6) ein übliches Bauteil der Fernsehgeräte für das breite Publikum ist.

12. Empfänger nach einem der Ansprüche 10 und 11, dadurch gekennzeichnet, daß die Videosignal-Verzögerungsleitung (6) denjenigen entspricht, die in den Chrominanzschaltungen von Farbfernsehern für die Systeme NTSC, PAL oder PAL/SECAM verwendet werden, und daß die Dauer τ 64 µs beträgt.

13. Empfänger nach einem beliebigen der Ansprüche 10 und 11, dadurch gekennzeichnet, daß die Videosignal-Verzögerungsleitung (6) denjenigen entspricht, die in Videorecordern verwendet werden, und daß die Dauer τ 128 µs beträgt.

## Claims

1. Method of automatic gain control in a superheterodyne radio receiver by:
- splitting the intermediate frequency signal between two paths, a main signal path (3) and a secondary signal path (4);
- delaying by a time τ the intermediate frequency signal in said main signal path (3) and applying the delayed signal to the input of an amplifier (9);
- measuring the power of the intermediate frequency signal in said secondary signal path (4) during a time period less than or equal to said time τ;
- controlling the gain of said amplifier (9) according to said measured power;
said intermediate frequency being chosen among the frequencies routinely used for video signals in consumer equipment.

2. Method according to claim 1 characterised in that said intermediate frequency is between 1 MHz and 10 MHz.

3. Method according to claim 2 characterised in that said intermediate frequency is between 2.8 and 5.2 MHz.

4. Method according to claim 3 characterised in that said intermediate frequency is 4.43 ± 1 MHz.

5. Method according to claim 3 characterised in that said intermediate frequency is 3.58 ± 1 MHz.

6. Method according to any one of claims 1 to 5 characterised in that said time τ is less than 1 ms.

7. Method according to any one of claims 1 to 6 characterised in that said time τ is greater than 30 µs.

8. Method according to any one of claims 1 to 7 characterised in that said time τ is 64 µs.

9. Method according to any one of claims 1 to 7 characterised in that said time τ is 128 µs.

10. Superheterodyne radio receiver for implementing the method according to any one of claims 1 to 9, of the type comprising:
- a splitter (5) for splitting an intermediate frequency signal between a main signal path (3) and a secondary signal path (4);
- a delay line (6) on said main signal path (3) delaying said intermediate frequency signal by a time τ;
- a variable gain intermediate frequency amplifier (9) the input of which is connected to the output of said delay line (6);
- a signal power level detector (7) connected to said secondary signal path (4);
- a gain control device (8) on the output side of said power level detector (7) and whose output is connected to said amplifier (9) to control its gain;
said delay line (6) being a video delay line.

11. Receiver according to claim 10 characterised in that said video delay line (6) is of the type used in consumer television equipment.

12. Receiver according to claim 10 or claim 11 characterised in that said video delay line (6) is of the type used in colour television chrominance circuits to the NTSC, PAL or PAL/SECAM standard and in that said time τ is equal to 64 µs.

13. Receiver according to claim 10 or claim 11 characterised in that said video delay line (6) is of the type used in video tape recorders and in that said time τ is equal to 128 µs.
